Europäisches Patentamt

European Patent Office

Office européen des brevets

(19)

(11) Numéro de publication: **0 002 417**
**B1**

(12) **FASCICULE DE BREVET EUROPEEN**

(45) Date de publication du fascicule du brevet: **05.05.82**

(51) Int. Cl.³: **G 05 D 3/12, H 03 K 13/05**

(21) Numéro de dépôt: 78400213.1

(22) Date de dépôt: **05.12.78**

(54) Système d'asservissement de la position d'un organe mobile à des signaux numériques de commande, et interface numérique-analogique pour un tel système.

(30) Priorité: **07.12.77 FR 7736822**

(43) Date de publication de la demande:
**13.06.79 Bulletin 79/12**

(45) Mention de la délivrance du brevet:
**05.05.82 Bulletin 82/18**

(84) Etats contractants désignés:
**BE CH DE GB IT NL SE**

(56) Documents cités:
**FR - A - 1 230 575**

(73) Titulaire: **SOCIETE NATIONALE INDUSTRIELLE AEROSPATIALE**
**37 boulevard de Montmorency**
**F-75016 Paris (FR)**

(72) Inventeur: **Durandeau, Michel**
**27 rue Guynemer**
**F-31200 Toulouse (FR)**
Inventeur: **Verdier, Jean-Pierre**
**18 rue des Fleurs**
**F-31220 Cazeres-sur-Garonne (FR)**
Inventeur: **Voisin, Norbert**
**3 impasse du Soleil**
**F-31150 Bruguieres (FR)**

(74) Mandataire: **Akerman, Casimir et al,**
**23 boulevard de Strasbourg**
**F-75010 Paris (FR)**

Courier Press, Leamington Spa, England.

# Système d'asservissement de la position d'un organe mobile à des signaux numériques de commande et interface numérique-analogique pour un tel système.

La présente invention concerne un système d'asservissement disposé entre, d-une part, le circuit de commande d'un organe mobile, tel que la servovalve d'une servo-commande électrohydraulique, dont la position doit être commandée par des signaux électriques analogiques, et, d'autre part, un émetteur de signaux de commande de la position de l'organe mobile, que délivre des signaux électriques numériques, deux enroulements secondaires d'un capteur inductif de la position dudit organe mobile ainsi que le circuit de commande de ce dernier étant insérés dans une boucle fermée d'asservissement, ainsi qu'un interface numérique-analogique destiné à un tel système.

Avec le développement des techniques numériques, les signaux de commande destinés aux asservissements obéissant à des lois complexes sont de plus en plus fréquemment élaborés, non pas par des calculateurs analogiques, mais par des calculateurs numériques. C'est le cas notamment des systèmes de commandes électriques de vol des aéronefs, pour lesquels de nombreux paramètres interviennent avec des coefficients variables en fonction des conditions de vol. Cependant, l'asservissement propre de l'organe mobile commandé (une servo-commande de gouverne par exemple) ne peut exploiter de façon simple les signaux élaborés sous forme numérique, car les interfaces insérés entre le calculateur et la servo-commande sont des capteurs inductifs de position et des servo-valves, c'est-à-dire des dispositifs recevant ou délivrant des signaux de type analogique.

Dans l'état actuel de la technique, on connaît des capteurs de position qui délivrent directement un signal numérique, mais leur prix est très élevé, et, de plus, on ne peut envisager de les monter sur des servo-commandes d'aéronef, compte tenu des conditions sévères d'environnement régnant dans les zones non pressurisées où celles-ci sont placées.

On connaît également des dispositifs, actuellement en cours de développement, qui permettraient d'exploiter directement un signal numérique au niveau de l'étage de distribution d'un organe hydraulique de puissance. Mais le circuit électronique de puissance délivrant ces signaux est au moins aussi compliqué que celui devant être associé à une servo-valve pour obtenir un résultat comparable; de plus, pour éviter les effets de saturation en effort, et en vitesse, et pour ne pas interdire la surveillance du bon fonctionnement de l'organe commandé, on ne peut pas envisager, sur un aéronef, de supprimer le capteur de retour d'asservissement.

On connaît également différents types de convertisseurs analogique-numérique et numérique-analogique. Ces dispositifs sont d'un prix très élevé, ils sont complexes et peu adaptés à être unilisés dans un circuit de retour d'asservissement.

La publication FR-A-1 230 575 décrit un interface numérique-analogique inséré entre d'une part un émetteur de signaux de commande de la position d'un organe mobile, qui délivre des signaux numériques, et d'autre part un circuit de commande de cet organe mobile. L'interface comporte un circuit sommateur, dont le signal de sortie est utilisé pour commander l'organe mobile, et dont l'entrée est connectée aux deux enroulements secondaires d'un capteur inductif du type résolveur, un élément résistant, de valeur réglable en fonction de la valeur numérique du signal de commande, étant interposé entre l'un des enroulements et le circuit sommateur, de manière à agir sur la valeur de la tangente de l'angle correspondant à la position angulaire à imposer à l'organe mobile.

L'invention concerne un système d'asservissement de ce type général, mais comportant un capteur de type linéaire et un interface ayant des circuits sommateurs destinés à former une fonction particulière de la position d'un organe mobile.

Selon l'invention, le capteur inductif est de type linéaire à transformateur différentiel, ayant un plongeur mobile et dont les deux enroulements transmettent deux tensions ($V_1$, $V_2$) variant avec la position du plongeur mobile, la différence des deux tensions ($V_2-V_1$) étant proportionnelle à l'écart (X) du plongeur par rapport à une position de référence et la somme des deux tensions ($V_1+V_2$) étant proportionnelle à une constante A, et l'interface comprend deux circuits sommateurs destinés à former l'un la somme ($V_1+V_2$) des tensions du capteur et l'autre (29) leur différence ($V_2-V_1$), deux résistances dont l'une a une valeur fixe R et est reliée de manière qu'elle reçoive le signal ($V_2-V_1$) de l'un des circuits sommateurs et dont l'autre a une valeur réglable Ri et est reliée de manière qu'elle reçoive le signal ($V_1+V_2$) de l'autre des circuits sommateurs, des moyens pour régler la résistance réglable en function du signal numerique de commande à une valeur Ri pour agir sur la position de l'organe mobile de façon que Ri.X=R.A., et un circuit sommateur ayant une entrée destinée à recevoir les signaux transmis par les deux résistances et une sortie destinée à attaquer le circuit de commande de l'organe mobile.

La présente invention permet donc de réaliser un système d'asservissement et un interface simples pour les applications indiquées précedemment, et elle offre les possibilités avantageuses.

1° d'utiliser des capteurs de position commercialement disponibles, et non pas seulement des capteurs conçus spécialement pour présenter une faible dispersion sur leur rapport de transformation et de faibles variations de leurs évolutions en température,

2° d'alimenter ces capteurs à partir du secteur à 26 V et à 400 Hz prévus sur les avions, ou à partir d'alimentations de caractéristiques comparables, sans avoir à recourir à des générations électriques spéciales (d'où les avantages d'une fréquence plus élevée, d'une meilleure stabilité de la tension et de la fréquence, et d'un faible taux d'harmoniques), et

3° de ne pas avoir à moduler les signaux de commande en fonction de l'amplitude de la tension d'alimentation des capteurs pour s'affranchir des variations de cette dernière.

A titre d'exemple, on a décrit ci-dessous et illustré schématiquement au dessin annexé une forme de réalisation de l'invention.

La figure 1 représente un montage sommateur pour les signaux délivrés par un capteur inductif linéaire.

La figure 2 représente une variante du montage sommateur de la figure 1.

La figure 3 représente le schéma complet d'une seconde forme de réalisation de l'invention, utilisant un capteur inductif linéaire.

Sur ces figures, les mêmes éléments sont désignés par les mêmes références.

On va d'abord rappeler certaines caractéristiques des capteurs inductifs. Les paramètres affectant la précision du signal délivré par un capteur inductif sont:

a) l'erreur sur le rapport de transformation, qui se compose de:

1—l'erreur de fabrication, qui est de l'ordre de 2 à 5% sur les capteurs classiques, et de 1% sur les capteurs spécialement conçus;

2—l'erreur due aux variations de température, qui conduit parfois à adopter une fréquence d'alimentation supérieure à 400 Hz pour diminuer l'influence de la température sur le rapport de transformation;

b) l'erreur introduite par les variations de la tension d'alimentation de l'enroulement primaire, lesquelles se répercutent sur le signal délivré par l'enroulement secondaire (avec les mêmes conséquences qu'une variation du rapport de transformation);

c) l'erreur électrique ou l'erreur de linéarité qui est en général toujours supérieure ou égale à 1% du signal maximal obtenu dans la plage de débattement pour les capteurs linéaires.

Les erreurs prépondérantes sont celles dues à la dispersion sur le rapport de transformation des capteurs et celles dues aux variations de la tension d'alimentation.

La présente invention permet de minimiser ces erreurs grâce à un traitement particulier des informations qui sont délivrées par un capteur inductif linéaire à transformateur différentiel.

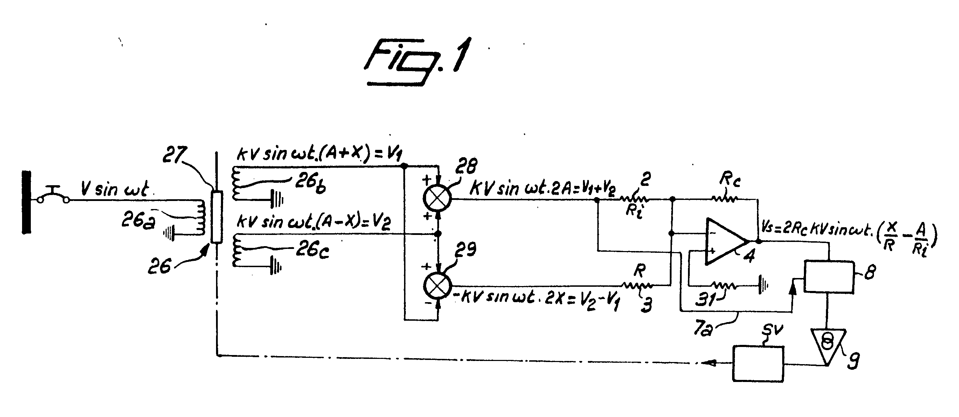

La figure 1 représente un montage sommateur pour les signaux délivrés par un capteur inductif linéaire à transformateur différentiel. Ce type connu de capteur est intéressant car il est très robuste du fait que sa seule pièce mobile ne comporte pas d'enroulement. Un tel capteur comprend essentiellement deux parties:

a) un corps, qui comporte trois enroulements: un enroulement primaire, alimenté par une tension alternative, et deux enroulements secondaires;

b) un plongeur ferromagnétique, qui se déplace suivant l'axe du corps, et qui distribue entre les deux enroulements secondaires le flux émis par l'enroulement primaire, en fonction de la position dudit plongeur par rapport au corps.

Le signal utile fourni par un tel capteur est la différence de tensions induites dans les deux enroulements secondaires. Ce signal est une fonction linéaire due déplacement du plongeur. La tige du plongeur est rendue solidaire, par exemple, du piston d'une servo-commande électro-hydraulique, dont le déplacement est évidemment linéaire et parallèle à la tige dudit piston.

La précision du signal produit par un capteur linéaire de ce type, comme dans le cas de tous les capteurs inductifs, est affectée par les variations de la tension d'alimentation et du rapport de transformation. Ledit signal est également affecté par les erreurs de linéarité. Un paramètre difficile à maîtriser, dans le cas de ce type de capteur, est le rapport de transformation. Une solution habituellement employée pour stabiliser la valeur de ce rapport consiste à alimenter l'enroulement primaire à des fréquences élevées, de l'ordre de 5000 à 10000 Hz. Cette solution implique cependant l'existence d'une source particulière d'alimentation pour l'excitation du capteur, ce qui est une complication et une cause supplémentaire de pannes.

L'invention remédie, entre autres, à ces inconvénients, et permet de s'affranchir des variations du rapport de transformation.

La figure 1 représente un capteur linéaire à transformateur différentiel 26, comprenant une enroulement primaire 26a, alimenté par un signal $V\sin\omega t$, un premier enroulement secondaire 26b, délivrant un signal $KV\sin\omega t.(A+X)=V_1$, un second enroulement secondaire 26c, délivrant un signal $KV\sin\omega t.(A-X)=V_2$, et un plongeur 27 dont la tige est, par exemple, solidaire du piston d'une servo-commande électrohydraulique, actionnant une gouverne d'aéronef.

L'expression des signaux délivrés implique que l'on définisse comme position zéro, la position relative du corps et du plongeur pour laquelle lesdits signaux sont égaux. A désigne une constante proportionnelle à l'amplitude desdits signaux lorsque $X=0$, X étant le déplacement linéaire relatif du corps et du plongeur, c'est-à-dire une grandeur égale ou directement proportionnelle au déplacement de l'organe commandé. K désigne le rapport de transformation du capteur linéaire.

On voit que:

$V_2+V_1=KV\sin\omega t.2A$

$V_2-V_1=KV\sin\omega t.2X$

Ces opérations sont réalisées respectivement par les circuits sommateurs 28 et 29, qui reçoivent chacun $V_1$ et $V_2$. Le circuit 28 réalise l'opération $V_2+V_1$, et le circuit 29, l'opération

$V_2-V_1$. La sortie du circuit 28 est reliée à l'entrée négative d'un amplificateur sommateur 4, par l'intermédiaire d'une résistance Ri. La sortie du circuit 29 est reliée à l'entrée négative de l'amplificateur 4 par l'intermédiaire d'une résistance R.

L'entrée positive de l'amplificateur 4 est reliée à la masse de l'ensemble par l'intermédiaire d'une résistance de réglage 31. Une résistance de contre-réaction, Rc, relie l'entrée négative à la sortie de l'amplificateur 4.

Le signal Vs à la sortie de l'amplificateur 4 a pour expression:

$$Vs = -\left[\frac{KV\sin\omega t.2A}{Ri} - \frac{KV\sin\omega t.2X}{R}\right].Rc$$

d'où:

$$VS = 2.Rc.KV.\sin\omega t\left[\frac{X}{R} - \frac{A}{Ri}\right]$$

Ce signal de sortie est nul lorsque

$$\frac{X}{R} = \frac{A}{Ri},$$

soit lorsque

$$\frac{X}{A} = \frac{R}{Ri} \text{ ou } \frac{V_1-V_2}{V_1+V_2} = \frac{R}{Ri};$$

on voit que

$$\frac{X}{A}$$

est indépendant du rapport de transformation du capteur 26 et de sa tension d'alimentation.

Il convient de noter que, si la position finale de l'organe commandé n'est pas affectée par les variations de V et de K, le signal d'erreur est par contre affecté par ces variations lorsqu'il n'est pas nul, c'est-à-dire en régime transitoire. En effet, il est proportionnel à

$$KV\sin\omega t\left[\frac{X}{R} - \frac{A}{Ri}\right]$$

Cependant, les erreurs pendant le régime transitoire sont d'importance secondaire, l'essentiel étant la précision sur la position finale de l'organe commandé.

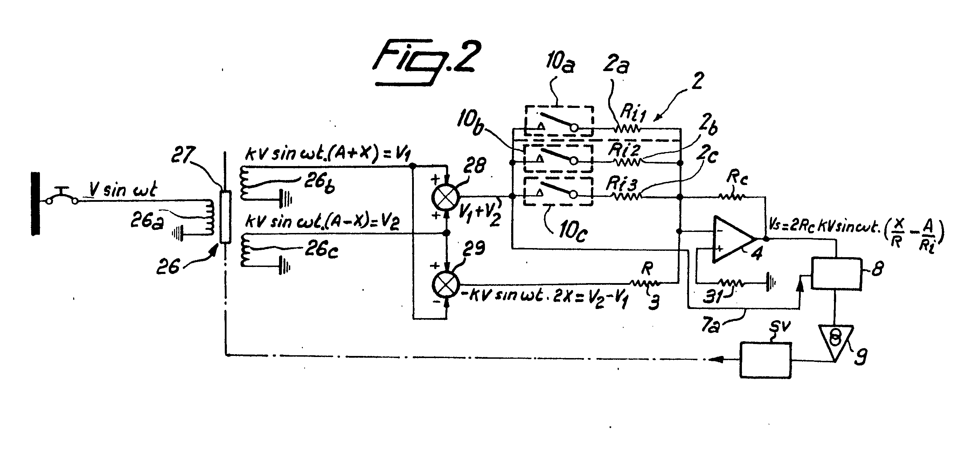

La figure 2 représente une variante du montage sommateur selon la figure 1, dans laquelle la résistance unique, de valeur Ri, a été remplacée par n résistances, 2a, 2b, 2c, .. de valeurs respectives $Ri_1$, $Ri_2$, $Ri_3$, ... etc., disposées respectivement en série avec n contacteurs, 10a, 10b, 10c, ... etc., de manière à pouvoir obtenir n positions différentes de l'organe commandé en fermant par exemple à chaque fois un seul des n contacteurs. Pour chacune de ces n positions, on obtient un signal d'erreur nul lorsque l'organe commandé a pris la position correspondant à la valeur Ri sélectionnée. Le montage de la figure 2 comporte en outre un démodulateur synchrone 8, recevant les signaux issus de la sortie de l'amplificateur 4 et, par une ligne 7a, une tension de référence, servant à la démodulation et provenant de la sortie $V_2+V_1$ du capteur 26. Ledit démodulateur 8 transforme le signal modulé en tension continue. Le signal démodulé est appliqué à un amplificateur de courant 9, qui alimente une servo-valve, SV, de commande d'une gouverne avec un signal analogique de courant.

Comme tension de référence de démodulation, le signal $(V_1+V_2)$, qui ne s'annule pas et ne change pas de phase dans la plage de débattement habituellement choisie, est transmis par la ligne 7a au démodulateur synchrone 8.

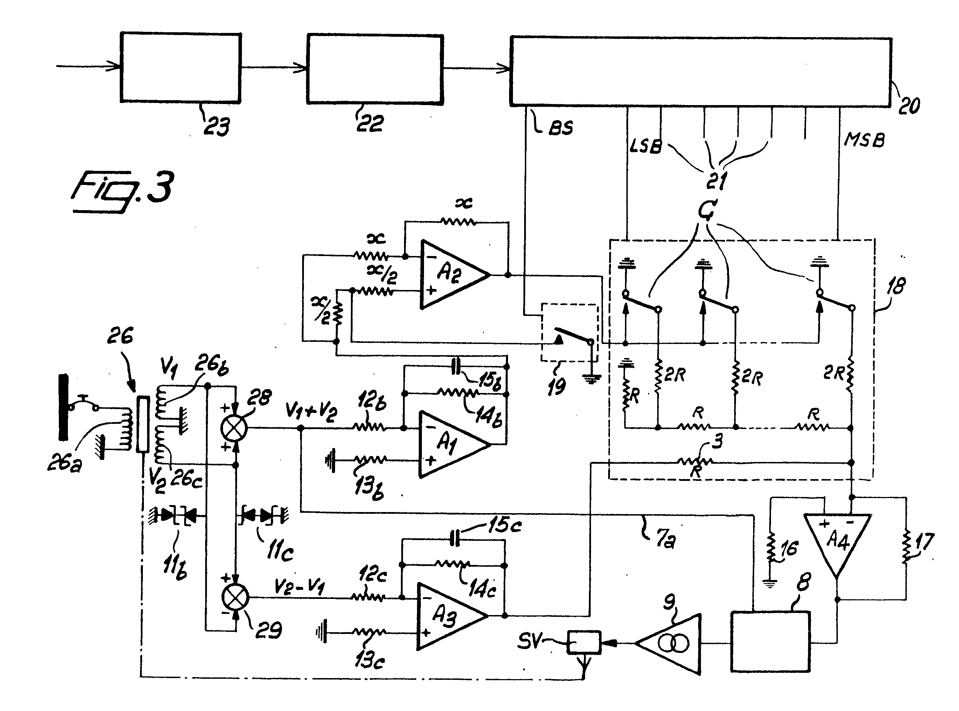

Dans le mode de réalisation de l'invention qui est illustré sur la figure 3, le groupe de résistances de valeur Ri et de contacteurs 10 de la figure 2 est remplacé par un réseau de résistances de valeurs R et 2R, du type connu comme réseau de décodage. Un tel réseau permet d'obtenir un grand nombre de valeurs de résistances (256 valeurs avec un réseau à 8 bits, 1024 avec un réseau à 10 bits, etc...). En commandant les contacteurs, incorporés ou non au réseau de résistances, et dont la fonction est comparable à celle des contacteurs 10a, 10b, 10c, ... de la figure 2, à l'aide d'un registre parallèle, on obtient la forme de réalisation de l'invention qui est illustrée sur la figure 3. Le circuit sommateur 28 est relié à l'entrée négative d'un amplificateur-adaptateur d'impédance, AI, par l'intermédiaire d'une résistance 12b. Deux diodes de Zener, 11b, sont montées en série, avec des polarisations inverses, entre l'enroulement 26b et la masse de l'ensemble. Une résistance 13b relie l'entrée positive de l'amplificateur AI à ladite masse. Une résistance 14b et une capacité 15b relient en parallèle la sortie de l'amplificateur AI à son entrée négative. Un montage identique est réalisé avec un amplificateur-adaptateur d'impédance, A3, pour le circuit sommateur 29, avec des composants 11c, 12c, 13c, 14c et 15c. Les diodes de Zener 11b et 11c servent à écrêter les surtensions de fortes valeurs. Les amplificateurs A1 et A3, montés en inverseurs, sont réglés pour adapter la dynamique du capteur à celle des étages suivants, et notamment à celle d'un réseau de résistances de valeurs R et 2R, 18. Ces réglages sont effectués à l'aide des résistances 12b, 12c et 13b, 13c et des résistances 14b, 14c de contre-réaction. Les capacités 15b et 15c servent à filtrer les parasites de fréquences élevées.

La sortie de l'amplificateur A3 est reliée à l'entrée négative d'un amplificateur sommateur A4, monté en inverseur, par l'intermédiaire d'une résistance 3 de valeur R; avantageusement, cette résistance 3 est la résistance habituellement utilisée pour appliquer une contre-réaction à l'amplificateur sommateur de sortie, A4, et elle est intégrée, à la fabrication, dans le réseau de résistances 18. De ce fait, ladite résistance 3 a exactement la même valeur que les autres résistances de valeur R dudit réseau 18. L'entrée négative de l'amplificateur A4 est également connectée à la sortie du réseau de résistances 18. L'entrée positive de l'amplificateur A4 est reliée à la masse de l'ensemble par l'intermédiaire d'une résistance de réglage 16. La sortie de l'amplificateur A4 est reliée à son entrée négative par l'intermédiaire d'une résistance de contre-réaction 17.

La sortie de l'amplificateur A1 (correspondant au signal $V_1+V_2$) est reliée aux entrées négative et positive d'un amplificateur A2, en parallèle et par l'intermédiaire, pour son entrée négative d'une résistance de valeur x, et pour son entrée positive, de deux résistances de valeur x/2, qui sont montées en série, et dont le point milieu est relié à la masse par l'intermédiaire d'un contacteur 19, actionné par le bit de signe fourni par la sortie BS d'un registre parallèle 20.

Une autre résistance, de valeur x, est montée en contre-réaction entre la sortie de l'amplificateur A2 et son entrée négative. La sortie de l'amplificateur A2 est reliée à l'entrée du réseau de résistances 18. Les contacteurs C dudit réseau 18 sont actionnés respectivement par les sorties 21 dudit registre parallèle 20. Celui-ci reçoit sur son entrée des signaux de sortie d'un circuit de transformation série-parallèle 22, qui reçoit lui-même sur son entrée les signaux de sortie d'un circuit de décodage 23. L'entrée du circuit de décodage 23 constitue l'entrée de l'interfaces numérique-analogique selon la présente invention, qui reçoit les messages numériques série, destinés à la commande de l'organe commandé, par exemple la servo-valve SV d'une servo-commande actionnant une gouverne d'un aéronef.

En raison du montage de l'amplificateur A2 avec les résistances de valeur x et x/2, ledit amplificateur A2 a un gain de valeur 2 sur son entrée positive, et un gain de valeur −1 sur son entrée négative. Lorsque le contacteur 19 est ouvert, le signal issu de l'amplificateur A1 est reçu par les deux entrées de l'amplificateur A2, dont le gain total vaut: $+2+(-1)=+1$. Lorsque le contacteur 19 est fermé, le signal issu de l'amplificateur A1 n'est reçu que par son entrée négative, et le gain de l'amplificateur A2 vaut −1. Le signal de sortie de l'amplificateur A2 est alors en opposition de phase avec le signal d-entrée (issu de l'amplificateur A1). Il est par contre en phase avec le signal d'entrée lorsque le contacteur 19 est ouvert. Ce montage permet donc de donner le signe+ou−au signal $V_1+V_2$ correspondant au message série reçu par le décodeur 23, à l'aide du bit de signe BS et de définir ainsi un débattement de l'organe commandé par rapport à une position moyenne (ou position zéro), par exemple la position d'une gouverne de direction dans le plan de l'empennage correspondant. L'amplificateur A2 et ses circuits annexes constituent donc un circuit inverseur de phase, commandé par le contacteur 19.

Le message série reçu par le décodeur 23 provient, par exemple, d'un calculateur de vol ou d'une ligne omnibus; il est décodé par le décodeur 23 et transformé par le circuit 22 en message parallèle. Ledit message parallèle est introduit dans le registre 20, qui actionne sélectivement les contacteurs C de façon à former à l'aide du réseau 18, une résistance correspondant à une valeur déterminée de X/A, c'est-à-dire à une position linéaire relative déterminée du plongeur du capteur 26, et par suite de l'organe commandé.

Le signal $V_1+V_2$, traité par le réseau de résistances 18, est sommé avec le signal $V_2-V_2$ par l'amplificateur A4 qui délivre un signal analogique, modulé, d'erreur de position. Après démodulation synchrone dans le démodulateur 8 et amplification par l'amplificateur 9, comme dans le cas de la figure 2, ce signal est transmis à la servo-valve SV d'une servo-commande.

L'ensemble illustré sur la figure 3 et décrit ci-dessus constitue donc bien un interface numérique-analogique, insérable entre un émetteur d'ordres numériques de commande et un organe à commander par des signaux analogiques. Le nombre de valeurs commandées possibles de X/A est égal à $2^N$, N étant le nombre de bits que le réseau de résistances 18 peut recevoir en provenance du registre 20. L'ordre de commande est un signal numérique, représentatif de la position de consigne du capteur, et comportant un bit pour le signe, et d'autres bits pour la valeur absolue. Ces derniers bits actionnent les contacteurs C du réseau 18, tandis que le bit de signe actionne le contacteur 19 qui permet d'appliquer le signal $V_1+V_2$ en phase ou en opposition de phase à l'amplificateur A4.

Selon l'invention, il est également possible d'utiliser un réseau de résistances de valeurs R et 2R à registre incorporé et d'utiliser par exemple un signal numérique en code dit "binaire décalé" ce qui permet de supprimer le contacteur 19.

**Revendications**

1. Système d'asservissement de la position d'un organe mobile à des signaux de commande de la position de cet organe, destiné à être inséré entre d'une part le circuit de commande d'un organe mobile, tel que la servo-valve (SV) d'une servo-commande électrohydraulique, dont la position doit être commandée par des signaux électriques analogiques, et d'autre part un émetteur de signaux de commande de la position de l'organe mobile qui délivre des signaux électriques numériques, ledit système d'asservissement étant du type à boucle fermée qui comporte un capteur inductif (26) destiné à détecter la position dudit organe mobile et ayant deux enroulements secondaires (26b, 26c), et un interface comprenant un circuit sommateur (4, A4) dont la sortie attaque le circuit de puissance de l'organe à commander et dont l'entrée est connectée aux deux enroulements secondaires (26b, 26c) du capteur inductif, ledit système d'asservissement étant caractérisé en ce que:

le capteur inductif (26) est de type linéaire à transformateur différentiel ayant un plongeur mobile et dont les deux enroulements secondaires (26b, 26c) transmettent deux tensions $(V_1, V_2)$ variant avec la position du plongeur mobile, la différence des deux tensions $(V_2-V_1)$ étant proportionnelle à l'écart (X) du plongeur par rapport à une position de référence et la somme des deux tensions $(V_1+V_2)$ étant proportionnelle à une constante A, et:

l'interface comprend:

— deux circuits sommateurs (28, 29) destinés à former l'un (28) la somme $(V_1+V_2)$ des tensions du capteur et l'autre (29) leur différence $(V_2-V_1)$,

— deux résistances dont l'une (3) a une valeur fixe R et est reliée de manière qu'elle reçoive le signal $(V_2-V_1)$ de l'un (29) des circuits sommateurs, et dont l'autre (2, 18) a une valeur réglable Ri et est reliée de manière qu'elle reçoive le signal $(V_1+V_2)$ de l'autre (28) des circuits sommateurs,

— des moyens pour régler la résistance réglable (2, 18) on fonction du signal numérique de commande à une valeur Ri pour agir sur la position de l'organe mobile de façon que Ri.X=R.A, et,

— un circuit sommateur (4, A4) ayant une entrée destinée à recevoir les signaux transmis par les deux résistances et une sortie destinée à attaquer le circuit de commande de l'organe mobile (SV).

2. Interface numérique-analogique destiné à un système d'asservissement selon la revendication 1, ledit interface étant destiné:

— à commander la position d'un organe mobile, tel que la servo-valve (SV) d'une servo-commande électro-hydraulique dont la position doit être commandée par des signaux électriques analogiques,

— à recevoir des signaux électriques numériques d'un émetteur de signaux de commande de la position de l'organe mobile,

— à recevoir deux tensions $(V_1, V_2)$ de deux enroulements d'un capteur inductif linéaire (26) à transformateur différntiel ayant un plongeur mobile, la différence des deux tensions $(V_2-V_1)$ étant proportionnelle à l'écart (X) du plongeur par rapport à une position de référence et la somme des deux tensions $(V_1+V_2)$ étant proportionnelle à une constante (A),

ledit interface étant caractérisé en ce qu'il comprend:

— deux circuits sommateurs (28, 29) destinés à former l'un (28) la somme $(V_1+V_2)$ des tensions du capteur et l'autre (29) leur différence $(V_2-V_1)$,

— deux résistances dont l'une (3) a une valeur fixe R qui est reliée de manière qu'elle reçoive le signal $(V_2-V_1)$ de l'un (29) des circuits sommateurs, et dont l'autre (2, 18) a une valeur réglable Ri et est reliée de manière qu'elle reçoive le signal $(V_1+V_2)$ de l'autre (28) des circuits sommateurs,

— des moyens pour régler la résistance réglable (2, 18) a une valeur Ri en fonction du signal numérique de commande, et

— un circuit sommateur (4, A4) ayant une entrée destinée à recevoir les signaux transmis par les deux résistances et une sortie destinée à attaquer le circuit de commande de l'organe mobile (SV).

3. Interface selon la revendication 2, caractérisé en ce que la résistance réglable (2) est matérialisée par un réseau (18) de type connu comme réseau de décodage, qui est formé par des résistances de valeurs R et 2R, et avec des contacteurs (C), et qu'un décodeur (23), un circuit de transformation série/parallèle (22) et un registre parallèle (20) sont montés en série entre l'émetteur de signaux de commande et les circuits respectifs de commande des contacteurs (C) dudit réseau (18).

4. Interface selon la revendication 3, caractérisé en ce qu'un circuit inverseur de phase (A2, x, x/2) associé à un contacteur (19) d'inversion de phase, est inséré en amont de la résistance (2, 18) de valeur réglable Ri, et qu'une ligne relie le circuit de commande dudit contacteur (19) à la sortie (BS) du registre parallèle (20) correspondant au bit de signe du signal numérique de commande.

5. Interface selon l'une quelconque des revendications 2 à 4, caractérisé en ce qu'un démodulateur synchrone (8) est inséré entre la sortie du circuit sommateur (4) et la sortie de puissance (9) de l'organe à commander (SV), et qu'une ligne (7a) relie l'entrée de synchronisation du démodulateur (8) à un point du montage, situé en amont de la résistance réglable (2, 18).

6. Interface selon l'une quelconque des revendications 2 à 5, caractérisé en ce que deux circuits filtrants et adaptateurs d'impédance sont insérés respectivement en amont des deux résistances (3; 2, 18) de valeurs fixe R et réglagle Ri.

**Claims**

1. A follow-up system for subjecting the position of a moving member to signals for controlling the position of this member, which system is intended to be inserted between, on the one hand, the control circuit of a moving member such as the servo-valve (SV) of an electro-hydraulic servo-control means, the position of which has to be controlled by analog electrical signals, and on the other hand, an emitter of signals controlling the position of the moving member that supplies digital electrical signals, said follow-up system being of the closed-loop type which comprises an inductive pick-up (26) intended to detect the position of said moving member and having two secondary windings (26b, 26c), and an interface comprising a summation circuit (4, A4), the output of which is applied to the power circuit of the member to be controlled, and the input of which is connected to the two secondary windings (26b, 26c) of the inductive pick-up, said follow-up system being characterized in that:

the inductive pick-up (26) is of the linear type having a differential transformer with a moving plunger, and the two secondary windings (26b, 26c) of which transmit two voltages $(V_1, V_2)$ varying with the position of the moving plunger, the difference between the two voltages $(V_2-V_1)$ being proportional to the distance $(X)$ of the plunger from a reference position, and the sum of the two voltages $(V_1+V_2)$ being proportional to a constant A, and

the interface comprises:

— two summation circuits (28, 29), one (28) of which is intended to form the sum $(V_1+V_2)$ of the voltages of the pick-up, and the other (29) the difference $(V_2-V_1)$ between them,

— two resistors, one (3) of which has a fixed value R and is connected in such manner that it receives the signal $(V_2-V_1)$ of one (29) of the summation circuits while the other resistor (2, 18) has an adjustable value Ri and is connected in such manner that it receives the signal $(V_1+V_2)$ of the other (28) of the summation circuits,

— means for adjusting the adjustable resistor (2, 18) as a function of the digital control signal to a value Ri so as to act on the position of the moving member in such manner that Ri.X=R.A, and

— a summation circuit (4, A4) having an input intended to receive the signals transmitted by the two resistors, and an output intended to be applied to the control circuit of the moving member (SV).

2. A digital-analog interface intended for a follow-up system in accordance with claim 1, said interface being intended:

— to control the position of a moving member such as the servo-valve (SV) of an electro-hydraulic servo-control means, the position of which has to be controlled by analog electrical signals.

— to receive digital electrical signals from a transmitter of signals controlling the position of the moving member,

— to receive two voltages $(V_1, V_2)$ from two windings of a linear inductive pick-up (26) having a differential transformer with a movable plunger, the difference between the two voltages $(V_2-V_1)$ being proportional to the distance $(X)$ of the plunger from a reference position, and the sum of the two

voltages $(V_1+V_2)$ being proportional to a constant (A), said interface being characterized in that it comprises:

— two summation circuits (28, 29), one (28) of which is intended to form the sum $(V_1+V_2)$ of the voltages of the pick-up, and the other (29), their difference $(V_2-V_1)$,

— two resistors, one (3) of which has a fixed value R and is connected in such manner that it receives the signal $(V_2-V_1)$ of one (29) of the summation circuits, while the other resistor (2, 18) has an adjustable value Ri and is connected in such manner that it receives the signal $(V_1+V_2)$ of the other (28) of the summation circuits,

— means for adjusting the adjustable resistor (2, 18) to a value Ri as a function of the digital control signals, and

— a summation circuit (4, A4) having an input intended to receive the signals transmitted by the two resistors, and an output intended to be applied to the control circuit of the moving member (SV).

3. An interface according to claim 2, characterized in that the adjustable resistor (2) is constituted by a known type of decoding network (18), which is formed by resistors having ratings of R and 2R, and with contactors (C), and in that a decoder (23), a series/parallel conversion circuit (22) and a parallel register (20) are arranged in series between the control-signal emitter and the respective control circuits of the contactors (C) of said network (18).

4. An interface according to claim 3, characterized in that a phase-inverting circuit (A2, x, x/2), associated with a phase-inversion contactor (19), is inserted upstream of the resistor (2, 18) of adjustable value Ri, and in that a line connects the control circuit of said contactor (19) to the output (BS) of the parallel register (20) corresponding to the bit having the sign of the digital control signal.

5. An interface according to any one of claims 2 to 4, characterized in that a synchronous demodulator (8) is inserted between the output of the summation circuit (4) and the power output (9) of the member (SV) to be controlled, and in that a line (7a) connects the synchronization input of the demodulator (8) to a point in the assembly that is situated upstream of the adjustable resistor (2, 18).

6. An interface according to any one of claims 2 to 5, characterized in that two filtering and impedance adaptation circuits are inserted upstream respectively of the two resistors (3; 2, 18), one of which has a fixed value R and the other an adjustable value Ri.

**Patentansprüche**

1. Nachlaufsteuersystem für die Lage eines beweglichen Elements mittels Befehlssignale für die Stellung dieses Elements, welches einerseits zwischen einem Stelkreis für das bewegliche Element, beispielsweise ein Servo-

ventil (SV) einer elektrohydraulischen Servo-steuerung, deren Stellung durch elektrische Analogsignale gesteuert wird, und andererseits einem Befehlssignalgeber für die Stellung des beweglichen Elements eingesetzt werden soll, welcher elektrische numerische Siganle liefert, wobei das Regelsystem als geschlossene Schleife ausgebildet ist, die einen induktionsfühler (26) aufweist, der zur Erfassung der Stellung des beweglichen Elements dient und zwei Sekundärwicklungen (26b, 26c) aufweist sowie eine Schnittstelle, die einen Summierkreis (4, A4) enthält, dessen Ausgang den Leistungskreis des zu steuernden Elements ansteuert und dessen Eingang an die beiden Sekundarwicklungen (26b, 26c) des induktionsfühlers angeschlossen ist, dadurch:

gekennzeichnet, daß der Induktionsfühler (26) von linearer Bauart mit Differentialtransformator ist, welcher einen beweglichen Tauchär-körper aufweist und dessen zwei Sekundärwicklungen (26b, 26c) zwei Spannungen ($V_1$, $V_2$) übertragen, die sich mit der Stellung des Tauchkörpers verändern, vobei der Unterschied zwischen den beiden Spannungen ($V_2-V_1$) dem Abstand (X) des Tauchkörpers von einer Bezugsstellung proportional ist, und ferner die Summe der beiden Spannungen ($V_1+V_2$) einer Konstanten A proportional ist, und ferner die Schnittstelle folgende Teile unfaßt:

— zwei Summierkreise (28, 29), wovon der eine (28) die Summe ($V_1+V_2$) der Span-nungen des Induktionsfühlers und der an-dere (29) ihre Differenz ($V_2-V_1$) bildet,
— zwei Widerstände, wovon der eine (3) einen Festwert R aufweist und derart angeschlossen ist, daß er das Signal ($V_2-V_1$) des einen (29) der Summierkreise empfängt, während der andere (2, 18) einen verstellbaren Wert Ri aufweist und derart angeschlossen ist, daß er das Signal ($V_1+V_2$) des anderen (28) der Summierkreise empfängt,
— Einrichtungen zur Einstellung des einstellbaren Widerstands (2, 18) als Funktion des numerischen Steuersignals auf einen Wert Ri zwecks Einwirkung auf die Stellung des beweglichen Elements in solcher Weise, daß Ri·X=R·A, und
— einen Summierkreis (4, A4) weicher einen Eingang aufweist, der zur Aufnahme der von den beiden Widerständen übertragene Signale bestimmt ist, sowie einen Ausgang der zur Ansteuerung des stelikreises des beweglichen Elements (SV) dient.

2. Numerische-analoge Schnittstelle für ein Regelsystem nach Anspruch 1, weiches dazu dient,
— um die Stellung eines beweglichen Elements, beispielweise eines Servoventils (SV) einer elektrohydraulischen Servosteuerung zu steuern, dessen Position durch elektrische Analogsignale gesteuert werden soll,
— 'um elektrische numerische Signale zu empfangen, die von einem Befehlssignalgeber für die Stellung des beweglichen Elements geliefert werden,
— und um zwei Spannungen ($V_1$, $V_2$) von zwei Wicklungen eines linearen induktionsfühlers (26) mit Differential transformator aufzunehmen, welcher einen beweglichen Tauchkörper aufweist, wobei der Unterschied der beiden Spannungen ($V_2-V_1$) dem Abstand (X) des Tauchkörpers gegenüber einer Bezugsstellung proportional ist, während die Summe der beiden Span-nungen ($V_1+V_2$) einer Konstanten A propor-tional ist,
dadurch gekennzeichnet, daß die Schnittstelle folgende Teile aufweist:
— zwei Summierkreise (28, 29), wovon einer (28) die Summe ($V_1+V_2$) der Spannungen des Induktionsfühlers und der andere (29) ihre Differenz ($V_2-V_1$) bildet,
— zwei Widerstände, wovon der eine (3) einen Festwert R hat und derart angeschlossen ist, daß er das Signal ($V_2-V_1$) des einen (29) der Summierkreise empfängt, während der anders (2, 18) einen einstellbaren Wert Ri hat und derart angeschlossen ist, daß er das Signal ($V_1+V_2$) des anderen (28) der Summierkreise empfängt,
— Einrichtungen zur Einstellung des einstellbaren Widerstands (2, 18) auf einen Wert Ri abhängig vom numerischen Befehlssignal,
— einen Summierkreis (4, A4) welcher einen Eingang aufweist, der zur Aufnahme der durch die beiden Wicklungen übertragenen Signale dient, und einen Ausgang, der zur Ansteuerung des Stelikreises des beweglichen Elements (SV) vorgesehen ist.

3. Schnittstelle nach Anspruch 2, dadurch gekennzeichnet, daß der einstellbare Wederstand (2) durch ein Netzwerk (18) bekannter Art, wie beispielsweise ein Dekodiernetzwerk, gebildet wird, welches aus Widerständen mit den Werten R und 2R besteht, sowie aus Schaltern (C) und daß eine Dekodierschaltung (23), eine Serien/Parallel-Wandlerschaltung (22) und ein Parallelregister (20) in Reihe zwischen dem Befehlssignalgeber und den jeweiligen Steuerkreisen der Schalter (C) des Netzwerks (18) liegen.

4. Schnittstelle nach Anspruch 3, dadurch gekennzeichnet, daß eine Phasenwandlerschaltung (A2, x, x/2), die einem Phasenumkehrschalter (19) zugeordnet ist, dem Widerstand (2, 18) mit einstellbarem Wert Ri vorgeschaltet ist, und daß eine Leitung den Steuerkreis des Schalters (19) mit dem Ausgang (BS) des Parallelregisters (20) verbindet, entsprechend dem Vorzeichen-Bit des numerischen Steuersignals.

5. Schnittstelle nach einem der Ansprüche 2 bis 4, dadurch gekennzeichnet, daß ein synchroner Demodulator (8) zwischen dem Ausgang des Summierkreises (4) und dem Leistungsausgang (9) des zu steuernden Elements (SV) eingesetzt ist, und daß eine Leitung (7a) den Synchronisiereingang des Demodulators (8) mit

**0 002 417**

einem Schaltungspunkt verbindet, der sich vor dem einstellbaren Widerstand (2, 18) befindet.

6. Schnittstelle nach einem der Ansprüche 2 bis 5, dadurch gekennzeichnet, daß zwei Schaltungen zur Filtrierung und Impedanzanpassung jeweils vor den beiden Widerständen (3; 2, 18) mit dem Festwert R und dem einstellbaren Wert Ri angeordnet sind.

Fig.1

Fig.2

Fig.3